(19) Europäisches Patentamt
European Patent Office
Office européen des brevets

(11) **EP 2 565 291 A1**

(12) **EUROPEAN PATENT APPLICATION**

(43) Date of publication:
**06.03.2013 Bulletin 2013/10**

(51) Int Cl.:
*C23C 14/06* (2006.01)     *C23C 14/08* (2006.01)
*C23C 14/14* (2006.01)     *C23C 14/35* (2006.01)
*H01J 37/34* (2006.01)

(21) Application number: **11007077.8**

(22) Date of filing: **31.08.2011**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Hauzer Techno Coating BV
5928 LL Venlo (NL)**

(72) Inventors:
• **Papa, Frank**
  **5913 VK Venlo (NL)**
• **Tietema, Roel**
  **5926 SK Venlo (NL)**

(74) Representative: **Manitz, Finsterwald & Partner
GbR
Postfach 31 02 20
80102 München (DE)**

(54) **Vaccum coating apparatus and method for depositing nanocomposite coatings**

(57)     A vacuum coating apparatus and method comprising a vacuum chamber, at least one pair of opposing cathodes, a power supply adapted to supply an AC voltage to said opposing cathodes to operate them in a dual magnetron sputtering mode, wherein at least one further cathode for PVD coating is provided in said vacuum chamber, characterized in that the at least one further cathode is a magnetron cathode and a further power supply is provided in the form of a pulsed power supply or a DC power supply is provided which is connectable to the magnetron cathode or arc cathode.

Fig. 5

EP 2 565 291 A1

**Description**

The present invention relates to a vacuum coating apparatus and to a method for depositing hard coatings with good adhesion in particular for depositing nanocomposite coatings.

A nanocomposite is as a multiphase solid material where one of the phases has one, two or three dimensions of less than 100 <u>nanometers</u> (nm), or structures having nanoscale repeat distances between the different phases that make up the material. More specifically, for PVD deposited nanocomposite coatings, there is an amorphous phase (MeN) surrounding nanosize crystallites of a crystalline phase (MeN) (e.g. a-SiN/nc-TiN) or a metal phase surrounding a nanocrystalline MeN phase (Cu/MoN).

In the foregoing Me means any metal that can form a nanocomposite. Background information on nanocomposites can be found in the papers: "Possible role of oxygen impurities in degradation of nc- TiN/Si3N4 nanocomposites" by Stan Veprek, Pavla Karvankova and Maritza G.J Veprek-Heijman published on November 23rd 2005 in J. Vac. Sci. Tech., B23(6), pages L17 to L21,

"Superhard Nitride-Based Nanocomposites, Role of Interfaces and Effect of Impurities" by Shiqiang Hao, Bernhard Delley, Stan Veprek and Catherine Stampfl published in Physical Review Letters PRL 97 (2006) on pages 086102-1 to 086102-4 and

"Different approaches to superhard coatings and nanocomposites" by Stan Veprek, Maritza G.J Veprek-Heijman and Pavla Karvankova and Jan Prochazka in Thin Solid Films 476(2005), 1-29, Elsevier

Recently there has been increasing interest in nanocomposite material systems. Specific examples of such material systems are those generally described as metal silicon nitrides, metal carbon nitrides and metal carbon silicon nitrides. More particularly there has been special interest in coatings of metal silicon nitrides for use as hard material coatings on substrates such as cutting tools of metal, especially of steel, or on cermets or on other hard materials such as carbides, in particular tungsten carbides. Such coatings can also be used for tribological layers. The metals which can be considered for use in metal silicon nitrides are selected from the group comprising Ni, Zr, Mo, Ti, W, Cr, Al, V, and Co and also include combinations of two, three or more of these metals. Also there is interest in metal carbon nitrides which contain carbon rather than silicon and which are also used with the metals listed above as coatings on the same types of substrate. Furthermore, interest also exists in metal silicon carbon nitrides which, as the name implies, contain both carbon and silicon and can again be used with the same metals and for the same purposes as the metal silicon nitrides.

With metal silicon nitrides the percentage of silicon is typically between 1 and 20 atomic %. With carbon nitrides the percentage of carbon is typically between 1% and greater than 50 atomic%. For metal carbon silicon nitrides the percentage of carbon typically lies in the range of 1 to 50 atomic% and that of silicon to 1 to 20 atomic%. The specific ranges of percentages that are quoted vary depending on the metal that is selected. The amount of nitrogen is typically approximately that corresponding to the stoichiometric level required for the amount of the specific metal that is selected and for the selected amount of the other element(s) such as silicon, carbon or silicon and carbon. It can however be somewhat less than the stoichiometric amount or even slightly higher if nitrogen is incorporated in the layer in elemental form. Provided sufficient nitrogen is available for incorporation in the layer the amount of nitrogen incorporated as a nitride will be automatically determined by the process. For many materials, such al TiAlN or CrN, it is possible to make understoichiometric coatings when there is not enough nitrogen available during the process. However, it is not possible to make overstoichiometric coatings for such materials. Once the stoichiometric level is reached, the lattice cannot take up any extra nitrogen.

For materials such as TiN, all stoichiometries are possible. Therefore it is very important to control the N2 partial pressure during the process.

A typical example of a material system to which the present invention is directed is $Al_xSi_{1-x-y}N_y$. This material is obtained by depositing aluminum nitride and silicon nitride. It is always the case that $Si_3N_4$ is the amorphous matrix. The best way to describe the nanocomposites is that there are nanosize particles surrounded by a "tissue" of amorphous material. One can regard a nanocomposite as a bunch of marbles suspended in pudding!

Thus for $Al_xSi_{1-x-y}N_y$ there are nanosized grains of aluminium nitride in a matrix of $Si_3N_4$.

All metal/silicon nitrides are about the same as AlSiN. TiSiN is no different.

If a graph is drawn of the hardness of the coating as a function of the percentage of Si for AlSiN then this graph shows that the hardness increases from about 4 atomic % of Si and reaches useful values at between 6 and 9 atomic % and then continues at a steady level corresponding to the 6% level up to 20% and beyond. Thus the useful range of Si for aluminum as the metal is 6% to 9%.

Another example of a nanocomposite coating is $Ti_xSi_{1-x-y}N_y$ where the proportion of nitrogen is such that the material is chemically saturated so that it cannot take up any more nitrogen. This is achieved in the prior art by ensuring sufficient nitrogen is fed into the vacuum deposition chamber in a mixture of argon and nitrogen. For example a ratio $Ar:N_2$ of 1:3 can be used. The same consideration applies to the AlSiN system.

Another material system of particular interest is the $Me_aSi_bC_xN_y$, for example $Cr_aSi_bC_xN_y$. For material systems of this type it is almost impossible to assign values to a, b, x, and y since many ranges are possible and one cannot say a priori where the C and N will end up - in the matrix or in the nanoparticle.

It should be noted that small amounts of rare earth metals such as yttrium typically of less than 1% by weight can be added to any of the nanocomposite systems with advantage.

Although many nanocomposite systems of the above named kind are known they are difficult to manufacture because the processes used are difficult to control. The known processes include synthesis by reactive filtered arc deposition using both single and multi-elemental cathodes. As examples coatings of Al-SiO$_x$ and Al-SiN$_x$ have been deposited by this technique. The indentation hardness of Al-SiN$_x$ coatings was 22 GPa. In addition, Al-SiN$_x$ has been mixed with TiN$_x$ by a dual filtered arc method to produce nanocomposite TiAlSiN$_x$ films. Filtered arc coatings are very slow because the filtering aimed at avoiding droplets on the coated substrate frequently reduces the coating speed by a factor of one hundred related to normal arc coatings.

Coatings of NbC and NbN have been formed by reactive deposition using methane and nitrogen as the respective reactive gases and have hardness values in excess of 40 GPa. NbN/Ni nanocomposite coatings have been reported with a hardness of 63 GPa.

In reported work on a (Ti, Al, Si) N system the nanocomposite coatings structures were created by deposition of multilayer films of TiN and AlSiN, Particular attention was paid to the temperature effects on microstructural changes during annealing at 600°C. To realize the coatings, a rectangular aluminum vacuum chamber with three unbalanced sputtering magnetrons for the deposition of thin film coatings from different materials was used. The multilayer thin film coatings were prepared by reactive magnetron sputtering of multi thin film layers of TiN and AlSiN in a nitrogen containing atmosphere in the vacuum chamber. SNMS spectrometric investigation of the test samples show that a complete diffusion takes place between the different deposited thin film coating layers in each sample, even at low substrate deposition temperature. The high magnetic flux of the unbalanced magnetrons and the high sputtering power were able to produce a relatively high ion-to-atom flux leading to high mobility of the coated atoms. The interactions between the high mobility of the coated atoms and the ion-to-atom flux were sufficient to ensure diffusion between the different deposited thin layers. Analysis of the coatings showed that the structure of the formed mixture consists of two phases. One phase is noted as TiN bulk and another detected unknown amorphous phase can be SiNx or AlN or a combination of Ti-Al-Si-N.

Another report on nanocomposites relates to thin films of TiAlSiN deposited on SKD 11 tool steel substrates using two cathodes, of Ti and Al-15 at.% Si, in a cathodic arc plasma deposition system. The investigation considered the influence of AlSi cathode arc current and substrate bias voltage on the mechanical and structural properties of the films. The TiAlSiN films had a multilayered structure in which nanocrystalline cubic TiN layers alternated with nanocrystalline hexagonal AlSiN layers. The hardness of the films was found to decrease on increasing the AlSi cathode arc current. The hardness of the films also was also found to decrease as the bias voltage was raised from - 50 V to - 200 V. The maximum hardness of 43 GPa was achieved for films deposited at a pressure of 0.4Pa, at a Ti cathode arc current of 55A, at an Al cathode arc current of 35A, with the deposition taking place at a temperature 250°C and at a bias voltage of -50V.

Another approach to realizing superhard nanocomposite wear-resistant coatings by synthesis of a series of multicomponent and multiphase TiSiN, AlSiN and TiAlSiN coatings involved synthesis by a PECVD technique using liquid phase injection of alkoxide precursors.

In addition to the foregoing wear resistant nanocomposite coatings and apparatus for their manufacture are discussed in the web site of Platit AG, see: http://www.platit.com/coatings-structures?page=0%2C2

The principal object underlying the present invention is to provide a vacuum coating apparatus and a vacuum coating method for depositing nanocomposite coatings which allow excellent process control and thus excellent control and repeatability of the properties of the deposited layers, together with a high deposition rate and which ensure that the coatings have good technical properties with regard to adhesion, hardness, modulus of elasticity, smoothness and wear resistance. It is a further object to provide such apparatus and methods that can be provided and used at favorable cost. It is a yet further object to provide a fully flexible coating system.

In order to satisfy these objects there is provided a vacuum coating apparatus in accordance with claim 1. The vacuum coating apparatus comprises a vacuum chamber, at least one pair of opposing cathodes and a power supply adapted to supply an AC/DC voltage to said opposing cathodes to operate them in a dual magnetron sputtering mode, wherein at least one further cathode for PVD coating is provided in said vacuum chamber, the apparatus being characterized in that the at least one further cathode is a magnetron cathode or arc cathode and a further power supply is provided which is connectable thereto and is a DC or pulsed power supply.

Also in accordance with the present invention there is provided a method of manufacturing a coating on a substrate in a vacuum chamber in accordance with claim 14, the vacuum chamber having at least one pair of opposed cathodes and an AC power supply connectable to operate said cathodes in a dual magnetron sputtering mode and at least one further cathode having an associated power supply, the method being characterized in that the at least one further cathode and the pair of opposing cathodes are operated simultaneously in the coating mode whereby the pair of opposed cathodes generate an ionized plasma in the vacuum chamber between them which favors the operation of the at least one further cathode in a DC or pulsed power mode due to the presence of the ionized plasma. It should be noted that all the materials discussed in this application can be made from composite targets. However, these targets are expensive and it is difficult to make gradient layers or to change the doping levels. Therefore, it is much more cost effective to be able to blend materials from single element sources or targets. This also gives full flexibility.

The apparatus and the method of the present invention as recited in claims 1 and 14 and as set out above have preambles based on the prior art described in the European patent application EP 07819370.3 which was published as WO 2008/049634 and which describes so-called dual magnetron sputtering apparatus. The claims of the present application are based on the recognition that a dual magnetron sputtering apparatus which is generally used in glass coaters and is frequently used for sputtering from targets which are liable to so-called target poisoning can be used to particular advantage with a substantial synergistic effect for the deposition of nanocomposite coatings and indeed in a an apparatus and a method which makes it possible to satisfy the objects set out above.

Before discussing the use of dual magnetron sputtering for the purposes of the present teaching it is first instructive to consider dual magnetron sputtering as described in the named prior art document. Such a dual magnetron sputtering apparatus has two coating cathodes which alternately act as a cathode and an anode as a result of the AC voltage applied between them.

By way of example, when carrying out reactive sputtering with an aluminum cathode and using oxygen as the reactive gas, the cathode is initially clean aluminum. In the presence of oxygen a layer of aluminum oxide forms on the target cathode thus poisoning it. A layer of aluminum oxide also forms on the anode and this insulating layer means that the anode starts to "disappear" so far as the cathode is concerned. By changing the polarity of the power supply to the cathode and the anode, such that the cathode operates as an anode and the anode as a cathode, which inherently occurs in a dual magnetron sputtering apparatus because an alternating power source is connected between the two cathodes, the oxide film on the one cathode, which was previously an anode, is initially more negative because of the electrons which accumulated on the insulating layer and is more strongly bombarded with ions thus cleaning it, i.e. the partial insulating coating on the cathodes, is broken down again by the inert gas ions, such as argon ions, present in the chamber to which argon is also supplied. The coating of articles placed in the vacuum chamber effectively takes place alternately from the first and second cathodes which are operated anti-phase. When one cathode is operating as a cathode, the other cathode is operating as an anode. The voltage at the cathodes varies with the degree of poisoning of the target, i.e. of the cathode surface.

Dual magnetron sputtering systems are, for example, used in glass coating applications and there have two cathodes arranged alongside one another, with a supply of oxygen generally being located between them. The state of the art for a dual magnetron sputtering configuration (as it seems to be done in glass coaters) appears to use a voltage feedback signal to control the reactive gas flow to one of the cathodes in order to keep that cathode at a stable working point. However, problems arise in realizing such a control over a range of working conditions because of hysteresis in the relationship between the voltage feedback signal and the degree of poisoning of the cathode which is dependent on the reactive gas flow, on the amount of reactive gas which can react with the cathode and on the cleaning of the cathode which takes place in alternate half cycles.

The object underlying the invention described in the above mentioned WO 2008/049634 is to provide a magnetic sputtering apparatus in combination with a dual magnetron sputtering power supply which is able to operate in a stable manner over any desired length of a sputter coating phase, which ensures that the desired balanced operation of sputtering from each of the two cathodes is achieved and leads to a high quality sputtered coating with relatively inexpensive means. Furthermore, it is an object of the invention in said WO 2008/049634 to provide a magnetron sputtering apparatus in combination with a dual magnetron sputtering power supply, which is able to cope with voltage variations at the cathodes arising from the movement of individual articles to be coated and elements of the workpiece support for the articles (the workpiece table) through the space in front of the cathodes. It should also be able to take account of the fact that the vacuum pump used to maintain the vacuum chamber at the required low pressure level inevitably tends to remove more reactive gas from one cathode than the other cathode for symmetry reasons.

In order to satisfy these objects the named prior art application claims a dual magnetron sputtering power supply for use with a magnetron sputtering apparatus having at least first and second sputtering cathodes for operation in the dual magnetron sputtering mode, there being an AC power supply connected to the first and second sputtering cathodes, a means for supplying a flow of reactive gas to each of said first and second cathodes via first and second flow control valves each associated with a respective one of said first and second cathodes and each adapted to control a flow of reactive gas to the respectively associated cathode, the power supply having, for each of said first and second cathodes, a means for deriving a feedback signal relating to the voltage prevailing at that cathode, a control circuit for controlling the flow of reactive gas to the respectively associated cathode by controlling the respective flow control valve and adapted to adjust the respective flow control valve to obtain a voltage feedback signal from the respective cathode corresponding to a set point value set for that cathode, wherein said control circuit comprises a respective regulator for each cathode having as inputs the feedback signals from the cathodes and respective set point signals and producing as outputs a respective partial pressure set point signal, wherein a respective probe respectively associated with each cathode generates an actual pressure signal of the reactive gas, wherein the partial pressure set point signals and the respective actual pressure signals are applied to respective inputs of further regulators, the respective output signals of which serve to generate actuation signals for actuating the flow control valves supplying reactive gas to the respectively associated cathodes.

By providing a dual magnetron sputtering power supply of this kind it is possible to control the flow of the reactive gas to each of the cathodes, by controlling the respective flow control valves for the supply of reactive gas to each said cathode in such a way that balanced operation of a magnetron sputtering apparatus is achieved and thus a stable working point. Because each cathode becomes slightly poisoned during one half cycle of the AC power supply and is then partially cleaned again during the next half cycle, it is desirable to achieve an average degree of poisoning of each cathode which remains constant over many cycles of an AC power supply and indeed preferably for the degree of poisoning of each cathode to be the same, and indeed taking automatic account of the possible asymmetry of the removal of reactive gases from the vicinity of each of the cathodes by the vacuum pump associated with the vacuum chamber. The above recited system makes it possible to achieve this end.

It is particularly expeditious to measure the voltage prevailing at each of the cathodes with reference to earth or ground because this provides voltage feedback signals related to a common reference point (ground).

When used in the present invention the dual magnetron sputtering apparatus described in detail above not only makes it possible to deposit the generally non-conductive or insulating component of the coating but also provides a high degree of ionization in the vacuum chamber which greatly facilitates the operation of the at least one further magnetron cathode or arc source cathode in a pulsed or DC power mode, as will be explained in more detail in the specific description. This makes it possible to achieve higher deposition rates of the coating with good densification of the coating. One of the reasons for this is that the high ionization makes it possible to operate with a significantly higher ratio of inert gas to reactive gas. The higher ionization leads to a high rate of incorporation of the reactive gas in the coating despite the much lower proportion of reactive gas in the atmosphere of the chamber. The relatively much increased number of non-reactive inert gas ions in the atmosphere of the vacuum chamber enhance the densification and adhesion of the coating. Thus, by way of example, whereas the prior art reactive deposition of nitrides was effected using argon with a ratio of argon to nitrogen of 1:3, the present invention allows a higher deposition rate and good coating properties with an argon to nitrogen ratio of 3:1. The higher plasma density allows a good deposition rate and good coating properties resulting from the reduced nitrogen partial pressure

In addition a limitation on many coating processes is the amount of power supplied to the cathodes which must be restricted to keep the cathode temperature at a manageable level and to ensure it does not suffer damage due to melting. The present invention makes the deposition process significantly more efficient for the same heat input to the at least one further cathode, which will again be explained in more detail in the specific description. The increased bombardment with inert gas ions also seems to beneficially affect the reactions between the nitrogen ions and the elements of the coating layer and also the mobility of the constituents of the layer that is forming, leading to increased uniformity of the nanocomposite, and a smoother surface which is expected to beneficially affect the wearing effect of the coating on the rubbing partner and the coefficient of friction.

The further power supply is preferably one of a HIPIMS power supply, a modulated pulse power supply and a pulsed power supply with a maximum duty cycle in the range from 1 to 35%, preferably 3 to 33%, and especially from 10 to 30% or a DC power supply.

Although a HIPIMS power supply (high power impulse magnetron sputtering power supply) which is well known per se can be used to advantage with the present invention, the typical duty cycle of such a power supply is not actually ideal for the present invention and pulsed power supplies with a higher duty cycle as quoted above can be used to advantage without the danger of cathode (target) melting. Again this will be explained in more detail in the specific description.

More specifically the pulsed power supply used for the present invention preferably has a pulse repetition frequency of 1 to 2 kHz, preferably from 1 to 400 Hz, and especially from 10 to 200 Hz.

The apparatus in accordance with the present teaching is preferably adapted for simultaneous operation of said pair of opposing cathodes and said at least one further cathode.

This arrangement has the significant benefit that there are always large numbers of electrons moving to and fro between the opposing cathodes of the dual magnetron system throughout the volume of the chamber so that a high degree of ionization is always already present in the chamber whenever a power pulse is supplied to the at least one further cathode. This is very favorable for the operation of the at least one further cathode so that it does not first have to generate its own ionizing effect in the chamber. Moreover, this advantage prevails even when a particular substrate or workpiece is being primarily coated from the at least one further cathode, e.g. because the substrate or workpiece supporting table has rotated the substrate or workpiece to a position in the coating flux from the at least one further cathode and the coating flux from the dual magnetron cathodes is primarily directed to another workpiece or substrate within the chamber. This also applies when the coating flux from the dual magnetron cathode is directed to a different side of the substrate or workpiece being coated primarily by the coating flux from the at least one further cathode.

Thus these advantages also apply when multilayer coatings are being applied to a workpiece by substrate or workpiece rotation within the chamber (e.g. by any one of one fold, two fold, or three fold rotation) and when one workpiece is being simultaneously coated by the coating flux from the opposed dual magnetron cathodes and that from the at least one further cathode.

It is particularly convenient for the vacuum chamber to have either four or six cathode positions, there being two opposed cathode positions for the said pair of opposed cathodes and at least first and second further cathode positions for further cathodes, said further cathodes being either single cathodes or arrays of further cathodes.

Such a design allows for very flexible coating recipes including those where a metal oxide layer is provided as the top layer of the coating, for example in a coating of the type comprising a metal nitride layer on a substrate, a nanocomposite coating on the metal nitride layer, with the nanocomposite layer being made by reactive deposition from two different types of cathode, and a metal oxide top layer. It also applies when the nanocomposite coating is realized as a multilayer coating.

The ability to have plural cathodes or arrays of further cathodes at one or more coating positions is also very favorable. On the one hand it enables workpiece cleaning and etching in an efficient manner as described in the German utility model application 22 3010 09 497 of the present applicants and it also allows the use of a small cathode for the incorporation of a small amount of a particular element into the coating, for example an addition of yttrium, which can be and usually is mixed with another metal or present in an alloy with another metal.

The power supply adapted to supply an AC voltage to said pair of opposed cathodes is preferably also connectable to any other pair of opposed cathodes within said vacuum chamber.

Thus simple electrical switching circuitry can be used to vary the pair of opposed cathodes which are used as the dual magnetron cathodes. This again improves the flexibility of the apparatus.

More specifically first and second pairs of opposed cathodes are provided at first and second and third and fourth cathode positions within said vacuum chamber and first and second power supplies each adapted to supply an AC voltage to a pair of opposed cathodes can be connected to each of said pairs of opposed cathodes.

In a similar manner magnetron sputtering cathodes can be provided at any of said cathode positions and said pulsed power supply can be connected to selected magnetron cathodes at any of said cathode positions.

This again permits very flexible operation of the apparatus. E.g. a particular cathode can be used together with an opposed cathode in a dual magnetron sputtering mode to deposit insulating material and the same cathode can be used on its own or together with the opposing cathode in a different sputtering operation to deposit an electrically conductive coating .

The pair of opposed cathodes preferably consist of one of Al, Si, AlSi, $B_4C$ or carbon, such as a vitreous carbon or graphite, for the deposition of the corresponding nitrides using a nitrogen gas atmosphere, or consist of any metal or element having a non-conductive oxide, such as aluminium, titanium, silicon, tantalum, zirconium, vanadium, niobium, or tungsten, or any binary alloy therefrom, optionally with an addition of any rare earth metal for the deposition of the corresponding oxides using an oxygen gas atmosphere.

The above are prime examples of non-conducting coatings which are preferably reactively deposited using pairs of opposed cathodes operating in a dual sputtering mode.

The at least one further cathode can consist of metals forming a conductive metal nitride. The only metal which does not form a conductive nitride is aluminium. Silicon nitride $Si_3N_4$ is also not conductive. Thus these nitrides should be reactively deposited using aluminium or silicon targets in a nitrogen containing atmosphere using dual magnetron sputtering to sputter the aluminium and or silicon.

The apparatus in accordance with the present teaching preferably also includes a gas feed system for feeding any one of or any combination of inert gases, for example argon and neon, of reactive gases, for example nitrogen or oxygen, and a precursor for silicon, such as $HMDSO_4$, or TMS and/or for carbon-containing gases, for example $C_2H_2$ or $CH_4$.

This again improves the flexibility of the apparatus.

A control means is preferably provided for varying the ratio of inert gas to reactive gas. This makes it easy to exploit one of the advantages of the present invention which allows optimization of the coating and its properties through selection of an appropriate ratio of inert gas to reactive gas, for example as discussed above with reference to the relative proportion of argon and nitrogen.

All the magnetron cathodes are preferably UBM cathodes (unbalanced magnetron cathodes) and are preferably organized in a closed field arrangement so that north and south poles alternate around the periphery of the vacuum chamber.

Finally the present invention relates to a substrate selected from the group comprising cermets, metal carbides, hard metals, steels, and a coating thereon consisting of a composite of any one of TiN, TiAlN, AlTiN, AlCrN, and intermixed SiN, optionally with the additions of any rare earth material and optionally having a surface layer, or interspersed layers, or a mixed layer of $Al_2O_3$, AlCrO, AlSiO, in particular when made with the apparatus and/or by the method in accordance with the present teaching. The present invention particularly relates to a coated substrate of the above kind when the TiN, TiAlN, AlTiN, AlCrN material is reactively deposited with a proportion of nitrogen in the atmosphere of the vacuum chamber using said pair of opposed cathodes operated in dual magnetron sputtering mode and when said SiN is deposited reactively in said vacuum chamber simultaneously or sequentially with the deposition of material from said pair of opposed cathodes from said at least one further cathode, said oxide layer or layers being deposited reactively from a further one of said at least further cathodes, with the exception of $Al_2O_3$ which is deposited reactively from said pair of opposed cathodes, in both cases using aluminium as the cathode material and oxygen as a reactive gas.

The present invention will now be explained in more detail with reference to embodiments and to the accompanying drawings in which Figs. 1 to 4 are Figs. 1 to 4 of the earlier application published as WO 2008/049634 and Figs. 5 to 11 are figures relating to embodiments of the present invention. More specifically there are shown:

Fig. 1          a first practical embodiment of a dual magnetron sputtering power supply as used in accordance with the present invention and shown in schematic form,

Fig. 2A-2C      diagrams to explain the voltages present at two cathodes (cathode 1, Fig. 2B and cathode 4, Fig. 2C) fed in a magnetron sputtering apparatus by an AC voltage in accordance with Fig. 2A which is applied between them,

Fig. 3          a schematic diagram to illustrate the layout of a magnetron sputtering apparatus and to further explain the asymmetry of the removal of reactive gas the from the vaccum chamber by the vaccum pump,

Fig. 4          a preferred embodiment of the dual magnetron sputtering power supply,

Fig. 5          a schematic diagram similar to Fig. 3 but showing a first embodiment of the present invention,

Fig. 6          a graph to explain a particular advantage of the present invention,

Fig. 7          a diagram to describe the pulse duty cycle aspact of the present invention,

Fig. 8          a schematic diagram of a simple embodiment in accordance with the present invention having four magnetron cathodes,

Fig. 9          a schematic diagram of a preferred embodiment of the present invention similar to Fig. 5 but shown only with the doors closed and in highly schematic form, the embodiment having six cathode positions,

Fig. 10         a schematic diagram explaining a layer system which can be produced using apparatus in accordance with the present invention and

Fig. 11         a schematic diagram to explain a superlattice structure which can be produced using the present invention.

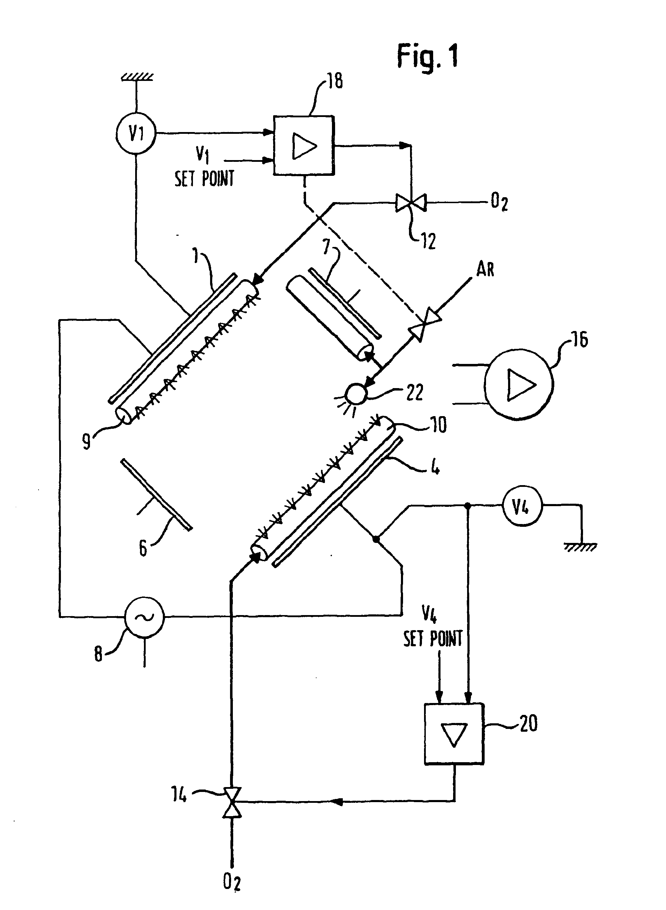

Turning now to Fig. 1, the attached drawing shows a dual magnetron sputtering power supply (DMS) in accordance with the present invention, as defined in the claims, the dual magnetron sputtering power supply is connected to first and second opposed cathodes 1 and 4. The cathodes 1 and 4 are located with other opposed cathodes 6 and 7 and optionally with further arc cathodes or magnetron cathodes (not shown) in a vacuum chamber (also not shown) and can be operated from an AC power supply 8 which usually is connected as shown in Fig. 1 so that alternating operation of the two generally opposed cathodes 1 and 4 is achieved. Each of the first and second cathodes 1 and 4 is equipped with a respective gas frame 9, 10 for the supply of reactive gas at an inlet near the respective cathode. The cathodes 1 and 4 are connected to the DMS (Dual Magnetron Sputtering) power supply 8. The cathodes may be, but do not necessarily need to be opposed to each other. State of the art for a DMS configuration (as it seems to be done in glass coaters) is that a voltage feedback signal controls the reactive gas flow (here: $O_2$ flow) to cathode 1, in order to keep the cathode at a stable working point (see literature of Bill Sproul on IRESS). The $O_2$ flow to the second cathode 4 is controlled in the prior art by an Optical Emission Controller.

In contrast, in accordance with the invention described in said WO 2008/049634, a voltage feedback signal ("V1-signal") from first cathode 1 (or from the DMS power supply) is used for control of a first $O_2$ inlet valve 12 at the first cathode 1, whereas control of a second $O_2$ inlet valve 14 at the second cathode 4 is governed by the voltage feedback signal ("V4-signal") of the second cathode 4. These are separate transmitters of voltage, measuring AC apparent voltage, AC rectified voltage or DC voltage. The elements shown in the drawing by symbols have their usual meaning. Thus, the triangle in a circle 16 represents the vacuum pump for producing the required operating vacuum in the chamber and the triangle in a square symbol signifies a feedback controlled regulator 18, 20 respectively.

In both cases the $O_2$-flow is increased until the respective cathode voltage reaches the set point value $V_{1\ SET\ POINT}$ and $V_{4\ SET\ POINT}$ respectively corresponding to the requirement of the control system. This set point value is generally chosen to be a DC voltage but it could also be a profiled, time dependent voltage. For $O_2$ this value is lower than the voltage in metallic (non-reactive) mode, at least when the cathodes are made of Al for forming, e.g., an $Al_2O_3$ coating. For other gas/metal combinations this might be a higher value.

The argon (Ar) flow for sputtering (non-reactive sputter gas) is supplied at a different place 22 than the $O_2$ inlet (in general this is the state of the art), but it could also be supplied near the cathode, e.g. at 22', or combined near the cathode. It can also be supplied at one of the other cathodes or centrally or at any other appropriate place in or adjacent to the vacuum chamber or system.

The control system is preferably realized with fast response MFC's (mass flow controllers), i.e. 18, 20, for reactive sputtering of oxygen or other difficult to sputter materials with a fairly big voltage difference between the metallic mode and the fully poisoned reactive mode. The problem of target poisoning is one of the prime reasons for using a dual mode magnetron sputtering system. For example, with an Al cathode and using $O_2$ as the reactive gas the cathode is initially clean aluminum. In the presence of reactive $O_2$ a layer of aluminum oxide forms on the target thus poisoning it. By changing the polarity of the power supplied to the cathode, inherent in DMS, the oxide film is broken down again by the inert gas ions in the chamber. Thus the coating of articles placed in the vacuum chamber effectively takes place alternately from the first and second cathodes which are operated anti-phase. The voltage at the cathodes varies with the degree of poisoning of the target (cathode surface).

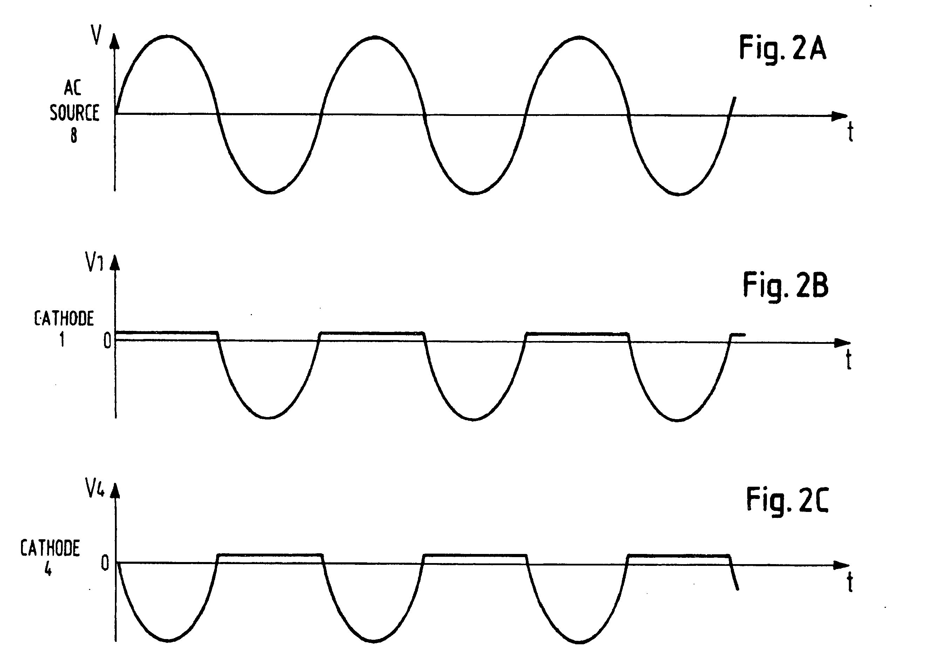

Turning now to Figs. 2A to 2C, an explanation can be given of how the sinusoidal wave form generated by the AC power source 8 as shown in Fig. 2A relates to the voltages at the two cathodes 1 and 4.

Because the two cathodes 1 and 4 are connected to respective output terminals of the AC source and because the conditions inside the vacuum chamber mean that this acts as a rectifier diode, the voltage at the cathodes 1 and 4 in each case corresponds to a negative half wave of the sinusoidal supply, with the two half waves being shifted relative to one another by 180° as shown in Figs. 2B and 2C. Because of the rectifying action of the magnetron sputtering apparatus, which operates in both directions, i.e. the polarity of the effective anode is reversed each half cycle, the voltage at the cathodes during the positive half phases is only slightly above zero and the cathode acts during this part of the cycle as an anode. Thus, during the negative half waves, the cathodes 1 and 4 act as cathodes, in the periods in between they act as anodes with a small anode voltage. When they are acting as cathodes, during the negative half cycles, reactive sputtering takes place from the respective cathode and the cathode surface is cleaned. During the period the respective cathodes act as an anode, i.e. each alternate half cycle, sputtered material accumulates on them, i.e. insulating material and this accumulated material is subsequently removed again during the next negative half cycle when the respective cathode is acting as a sputtering cathode. Thus, although the cathodes become contaminated, they are cleaned again during each half cycle in which they are acting as sputtering cathodes and the desired reactive sputtering takes place, with it being possible to keep the average degree of poisoning at each cathode 1, 4 constant over a long period of time.

It should be noted that the peak negative amplitude of the voltage present at the cathodes 1 and 4 as shown in Figs. 2B and 2C is generally desirably the same at each cathode, but is less than the open circuit output of the AC source 8 because of the average degree of target poisoning.

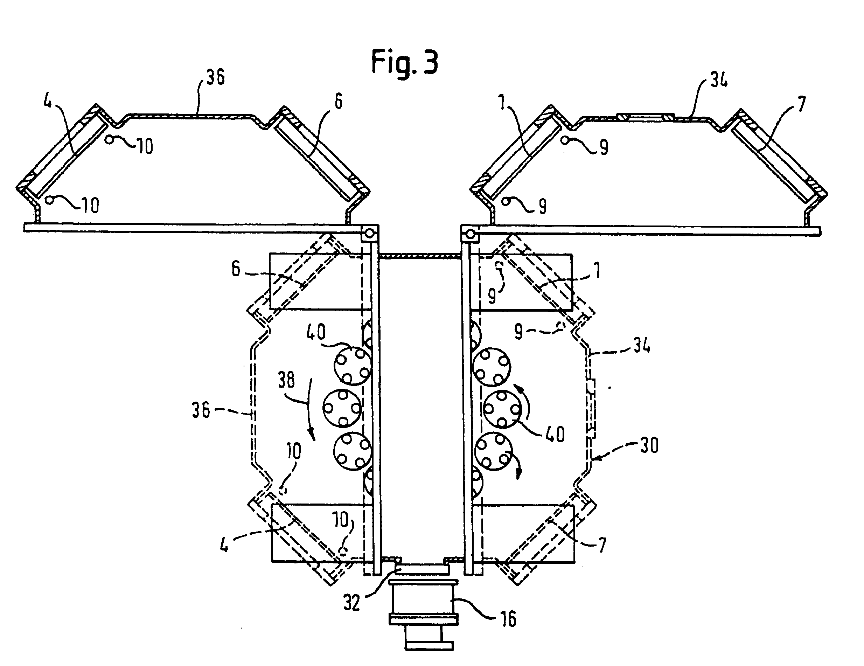

Turning now to Fig. 3 there can be seen a schematic drawing of a magnetron sputtering apparatus having a chamber 31 of generally octagonal shape in the traditional form used by Hauzer Techno Coating BV. The chamber 31 has a central portion 33 and two large hinged doors 34, 36 which each include two elongate, generally rectangular cathodes 1, 7 and 4, 6, which can thus be easily accessed for maintenance and exchange. The long sides of the rectangular cathodes are perpendicular to the plane of the drawing. Associated with each cathode 1, 7, 4, 6 is, in the usual way, a system of magnets (permanent magnets and/or magnetic coils) which generate the magnetic field necessary for magnetron operation. These magnet systems are not shown in any of the drawings of this application, and indeed this is not necessary because they are well understood by a person skilled in the art.

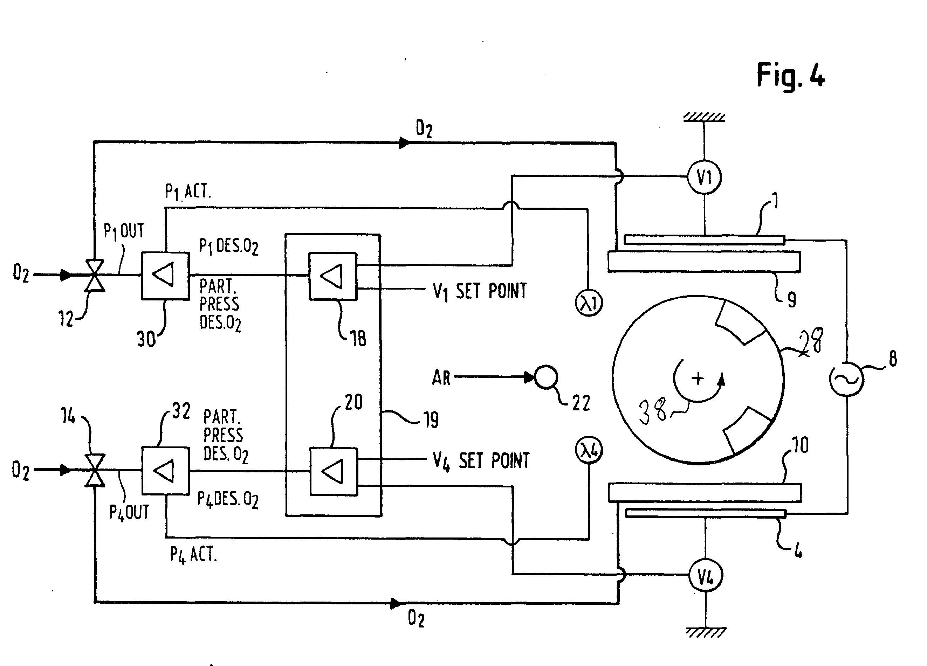

The pivotally mounted doors 34, 36 can be pivoted into the position shown in broken lines to close the chamber 31 in use. The chamber 31 typically has a generally octagonal base and octagonal cover which seal the chamber so that a vacuum can be generated therein by the vacuum pump 16. Within the chamber there is usually a rotary table 28 (see Fig. 4) which carries workpieces either directly or on further smaller rotary tables 40 which rotate about their own axes as well as rotating with the table 38 about the central vertical axis of the chamber.

It can be seen from Fig. 3 that the cathode 4 is closer to the vacuum pump 16 than the cathode 1, i.e. the generally opposed cathodes 1, 4 are asymmetrically arranged with respect to the vacuum pump 16 and this means that the vacuum pump 16 will tend to extract more reactive gas from the vicinity of the cathode 4 than from the vicinity of the cathode 1-This has to be compensated by increasing the supply of reactive gas via a respective gas frame 10 associated with the cathode 4 relative to the supply of reactive gas supplied via the gas frame 9 associated with the cathode 1.

Turning now to Fig. 4, a preferred embodiment of the dual magnetron sputtering power supply in accordance with the present invention will now be described. In this Figure, some reference numerals are common to the reference numerals used in Fig. 1 and it will be understood that these reference numerals refer to the same items as in Fig. 1 and that the same description applies unless something is specifically stated to the contrary. The vacuum chamber is again not shown in Fig. 4 for the sake of simplicity.

Again, the magnet systems associated with the cathodes 1 and 4 are not shown and also relative to Fig. 1 the further cathodes such as 6 and 7 have been omitted. The workpiece table 28, i.e. the table which carries the workpieces, is schematically illustrated between the opposed cathodes 1 and 4 as are the gas frames 9 and 10 associated with the respective cathodes. It should be noted that the gas frames do not necessarily have to extend around all four sides of the rectangular cathodes but typically extend along the two longitudinal sides of the elongate rectangular cathodes as shown by the drawings of Figs. 1, 3 and 4. The idea is to obtain a uniform gas distribution in front of the cathodes.

Fig. 4 shows, in distinction to Fig. 1, first and second lambda sensors, $\lambda_1$ and $\lambda_4$, which are arranged in the proximity of the cathodes 1 and 4 and of the gas frames 9 and 10. They serve to measure the partial pressure of the

EP 2 565 291 A1

reactive gas, in this case oxygen. If the reactive gas is a different gas, for example nitrogen, then obviously other probes have to be used which are sensitive to the concentration of the reactive gas being used.

In the embodiment of Fig. 4, as in the embodiment of Fig. 1, the voltage of each cathode relative to ground is measured and respective voltage signals V1 and V4, which comprise the actual voltage signals, are supplied to respective regulators 18 and 20 which can, for example, be completely separate regulators or can be integrated into a common control system as indicated by the block in Fig. 4. This can, for example, be an sps controller or regulator system 19 as well known per se. Each of the two regulators or controllers 18 and 20 receives a set point signal $V_{1SETPOINT}$, $V_{4SETPOINT}$ for the respective voltages V1 and V4, which can either be fixed voltages or can have a specific voltage profile desired for a particular operation. The controllers or regulators 18 thus each compare the actual measured voltage V1 and V4 with the respective set point voltage $V_{1SETPOINT}$ and $V_{4SETPOINT}$ and produce an output signal which represents a desired partial pressure signal for the reactive gas, in this case $O_2$, in the vicinity of the respective cathode 1 or 4. The values of $V_{1SETPOINT}$ and $V_{4SETPOINT}$ are generally the same as each other. The signals from the two lambda sensors, $\lambda_1$ and $\lambda_4$, provide a signal proportional to the actual partial pressure $P_{1ACT}$ and $P_{4ACT}$ respectively present in the vicinity of the cathodes 1 and 4. The boxes labeled 30 and 32 represent further regulators or controllers which then compare the desired partial pressure signals abbreviated $P_{1DES}.O_2$ and $P_{4DES}.O_2$, with the actual pressure signals $P_{1ACT}$ and $P_{4ACT}$ and produce output signals $P_{1OUT}$ and $P_{2OUT}$ which control the mass flow control flows 12 and 14 used to control the flow of the reactive gas, in this example $O_2$, to the respective gas frames 9 and 10. The input lines to the gas flow controllers 12 and 14 can come from a common source and they are simply schematically shown as if they come from different sources in Fig. 4.

In a dual mode magnetron sputtering system having workpieces on a movable workpiece table 28 there is a significant tendency for electrons in the vicinity of the cathodes 1 and 4 to be affected by gaps which appear on rotation of the workpiece table in such a way that they may tend to move to the other respective cathode when acting as an anode and thus result in fluctuation of the voltage signals $V_1$ and $V_4$. The regulators or controllers 18, 20 are selected to be relatively slow regulators so that they tend to smooth out voltage fluctuations and maintain the voltages $V_1$ and $V_4$ measured at the respective cathodes 1 and 4 within preselected bandwidths. Thus, fluctuations of the voltages $V_1$ and $V_4$ do not lead to instabilities in operation.

As stated earlier, the output signals of the regulators or controller 18, 20 are used as desired partial pressure signals for the partial pressures of the reactive gas present in the vicinity of the cathodes 1 and 4. The action of the output signals $P_{1OUT}$ and $P_{4OUT}$ of the further regulators 30 and 32 on the mass flow controllers 12 or 14 thus tries to correct the supply of reactive gas to the respective cathodes 1 and 4 so that the actual pressure values $P_{1ACT}$ and $P_{4ACT}$ correspond as closely as possible to the partial pressure desired signals $P_{1DES}.O_2$ and $P_{4DES}.O_2$. The respective partial pressures set in this way in turn vary the voltage feedback signals $V_1$ and $V_4$ and thus permit correction of the conditions prevailing at the cathodes 1 and 4 so that these are operated at or close to the desired set point values $V_{1SETPOINT}$ and $V_{4SETPOINT}$ respectively.

Although the further regulators 30 and 32 are described as hard regulators in the sense that they react quickly to changes of the desired partial pressures $P_{1DES}$ and $P_{4DES}$, it is believed that these could also be realized as soft regulators without significant disadvantage.

It should be noted that when using lambda sensors the character of the feedback signal means that a decrease of the set point value physically relates to an increase of the partial pressure (for example in mbar).

The actual pressures are sensed as samples and after each sampling interval a change of a set point can occur. The precise layout of the controls can include multiplication of signals with predefined values to improve the control response and to ensure that the system operates within the preset bandwidths.

It should also be noted that it is possible to build in alarms into the system such that if operating parameters move outside of the preset bandwidths an alarm signal is generated and optionally some other step is automatically taken to overcome the difficulty, for example shutdown of the apparatus until the reason for the alarm has been diagnosed and remedied.

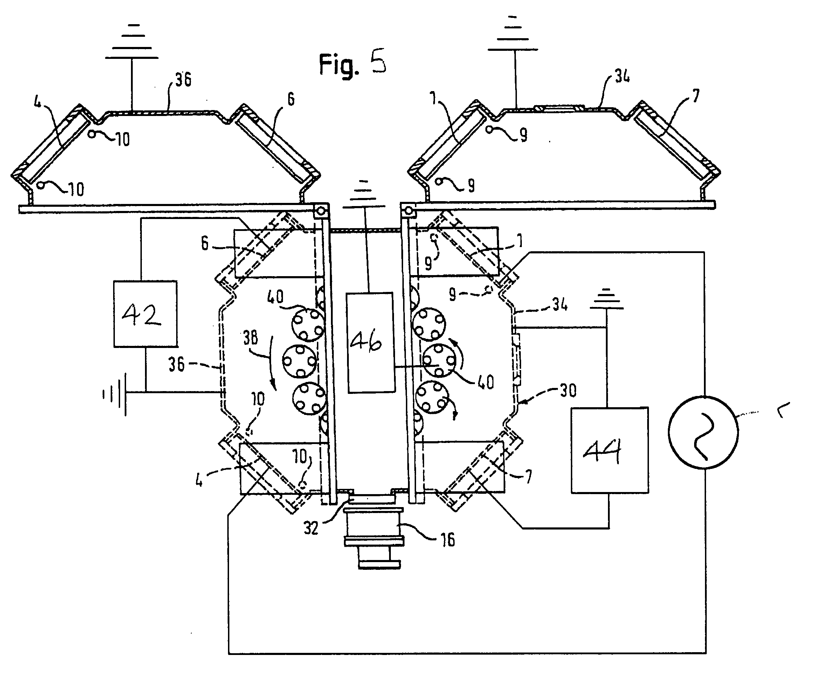

Turning now to Fig. 5 there can be seen a first embodiment of a vacuum coating apparatus in accordance with the present teaching. The apparatus is generally similar to the apparatus of Figs. 1 to 4 and the same reference numerals have been used to generate items common to Fig. 3 and the preceding figures or items having the same function. These items will not therefore be described in detail again. This convention also applies to all further figures.

The vacuum coating apparatus of Fig. 5 again comprises a vacuum chamber 31, at least one pair of opposing cathodes 1 and 4, a power supply 8 adapted to supply an AC voltage to said opposing cathodes 1 and 4 to operate them in a dual magnetron sputtering mode. The frequency of operation of the AC supply of a dual magnetron sputtering apparatus can be selected in a wide range from low frequency to radio frequency and is frequently selected to be in the range from 20-350 kHz, more specifically in the range from 20-100 kHz, and especially in the range from 25-75 kHz.

At least one further cathode for PVD coating is provided in said vacuum chamber and in this embodiment two such further cathodes 6 and 7 are provided. In this embodiment the further cathodes are magnetron cathodes and further power supplies 42 and 44 are provided which are connected to the cathodes 6 and 7 respectively for pulsed magnetron sputtering.

The further power supplies 42 and 44 are each selected to be one of a HIPIMS power supply, a modulated pulse power supply, a pulsed power supply with a maximum duty cycle in the range from 1 to 35 %, preferably 3 to 33 %, and especially from 10 to 30 % or a DC power supply. If a pulsed power supply is used then one with a duty cycle in one of the above ranges is preferred.

As indicated above the maximum average power which can be dissipated by and thus effectively applied to a cathode is the power which does not lead to an undesirable temperature increase of the cathode or unwanted melting thereof. Thus in a DC sputtering operation a maximum power of 20kW might be applied to a particular cathode. In HIPIMS operation a pulsed power supply is used which might typically apply power in 20$\mu$s wide pulses at a pulse repetition frequency of 5 kHz. Each pulse would then have a power associated with it of 180kW resulting in an average power of

$$P = 180kW \times (20\mu s/(200-20)\mu s = 20kW$$

For this example the maximum pulse power that can be supplied during a HIPIMS pulse is thus 180kW. This corresponds to a duty cycle of 20$\mu$s/ 180$\mu$s x 100 = 11%.

However, it must be borne in mind that a proportion of the HIPIMS pulse power is required to first generate ionization in the vacuum chamber before a significant cathode current can flow. For this reason the effective duty cycle is nearer to 5% than 11%. If the pulsed power supply does not have to do this because the ionization is supplied by the opposed cathodes 1 and 4 operating as dual magnetron cathodes then the effective power supplied to the further cathode(s) operating in a pulsed mode can be lower and significant cathode current can flow for virtually the full duration of the power pulse which enables longer effective pulses and a higher deposition rate. Thus it is possible to increase effective the duty cycle for the same material to 10 or 20% and even more. Nevertheless it is not essential to operate the apparatus at the maximum duty cycle and thus even duty cycles of 1% can be useful, particularly with complicated workpiece geometries where it is desired to obtain substantially uniform coatings on various surfaces of the workpieces. Thus duty cycles comparable to those of HIPIMS sputtering or lower can also be used to advantage in the present invention. It should be noted that defining a duty cycle is a tricky issue. This depends on the cathode size (related to machine type). Thus it may be more expedient to run at high frequency (high duty cycle) for a small cathode due to the lower absolute peak power required, while on a larger cathode, the duty cycle for the power supply may be lower since the peak power will be greater. There is no easy way to define this. For most processes it is best to operate with pulse lengths between 500-3000 $\mu$s and duty cycles between 3-30%. Most important concerning duty cycle is that for low temperature coatings, a low duty cycle will be chosen in order to reduce the average cathode power while keeping the peak cathode power high in order to have good film qualities. This is the main contrast to using DC sputtering. When changing average power with DC, the plasma density and thus the coating quality will change.

The pulsed power supply 42 or 44 used for the further cathodes 6 or 7 preferably has a pulse repetition frequency of 1 to 2 kHz, but this can be selected (without any restriction being intended) to lie in the range from 1 to 200 kHz, and indeed even in the range from 1 to 400 kHz.

The power supplies on the additional cathodes can be DC or pulsed supplies (for both arc cathodes (if used) and sputter cathodes). For pulsed magnetron sputtering the pulse repetition frequency is usually selected in the range from 1 to 400Hz an preferably in the range from 1 to 200 Hz. For example the pulse length could be selected in the range from 500 to 300 microseconds, however, these values are to be understood as a restriction. For arc cathodes one can consider similar ranges, again without any restriction being intended.

Frequency ranges for HIPIMS are 1-2 kHz, preferably 1-400 Hz. Frequency ranges for pulsed DC are 1-350 kHz, preferably 1-100 kHz, Frequency ranges for pulsed arc the same as for HIPIMS sputtering and the power supply is almost the same.

It will be noted in Fig. 5 that one terminal of each of the further power supplies 42 and 44 is connected to ground, which is conveniently selected to be the potential of the wall of the vacuum chamber whereas the other negative terminal is connected to the respective cathode 6 or 7. In the drawing of Fig. 5 the input terminals of the power supplies 42 and 44 are not shown in order to avoid unnecessarily complicating the drawing. One of the input terminals will typically be connected to ground as well.

The apparatus is adapted for simultaneous operation of said pair of opposing cathodes 1 and 4 and of said at least one further cathode 6 and/or 7.

This does not necessarily mean that any one workpiece is simultaneously exposed to the coating flux from all cathodes that are operating since this depends on the workpiece size and on the generally used rotation of the workpieces within the chamber (one fold, two fold or three fold rotation). Thus the apparatus of the invention as described with reference to Fig. 5 (or with reference to the subsequent figures) can be used to generate multilayer coatings by mounting the individual workpieces for rotation so that they are preferentially coated with the coating flux from successive cathodes or such that they are coated from all cathodes simultaneously. This can be achieved by selecting the type of rotation(s) involved and the speed(s) of this rotation or of these rotations.

One particular advantage of this is that a particular vacuum coating apparatus in accordance with the present invention can be used to deposit multilayer coatings or graded composition coatings or generally homogeneous coatings, depending on what is desired and this also contributes to the flexibility of the present apparatus This will be explained later in more detail.

The fact that the dual magnetron sputtering cathodes 1 and 4 are in operation at the same time as the at least one further cathode 6 and/or 7 ensures there is a high degree of ionization throughout the chamber because of the flow of electrons between the opposed dual magnetron cathodes which, as a result of their opposition and size "spans" the chamber. This applies even if the workpieces modulate the local ionization as a result of their presence, geometries and/or rotation.

Since the at least one further cathode 6 and/or 7 is/are operated in a pulsed mode it is necessary to use a pulse bias mode power supply, shown at 46 in Fig 5: However, it is definitely not necessary to use piulsed bias. Pulsed bias is only necessary for insulating coatings. For these coatings, it is preferable to have either pulsed, DC or RF bias, depending on the coating.

To ensure that the required substrate bias is always present even when high powers (currents) are flowing at the at least one further cathode 6 and/or 7 during the pulsed operation. Since each workpiece (substrate) is at the same bias voltage, because all workpieces are electrically connected to the rotary table 28 to which the bias voltage is applied, then the same substrate bias will be used both for dual magnetron sputtering of the opposed cathodes 1 and 4 and for pulsed magnetron operation of the at least one further cathodes 6 and/or 7. In addition to handling the high currents at the at least one further cathode 6 and/or 7 the bias power supply must be able to prevent the occurrence of arcing at any of the cathodes, in this case 1, 4, 6 and/or 7. The power supply best suited for the purposes of the present invention is a power supply in accordance with the European patent application published as WO2007/ 114819, especially in accordance with Fig. 1 thereof. As shown in Fig. 5 one terminal of the bias power supply 36, the positive terminal, is connected to ground, typically to the vacuum chamber wall at 31 and the negative output terminal is connected to the workpiece support table 28, although in Fig. 5 the connection is shown to one of the tables 40 since the table 28 carrying all the tables 40 and associated workpieces is not shown in Fig. 5. Electrically the potential at the table 28, at the tables 40 at the workpiece supports and at the workpieces is intended to be the same. The power input terminals of the bias power supply 46 are not shown in Fig. 4 to avoid complicating the drawing unnecessarily. One of the input terminals will however also be connected to ground.

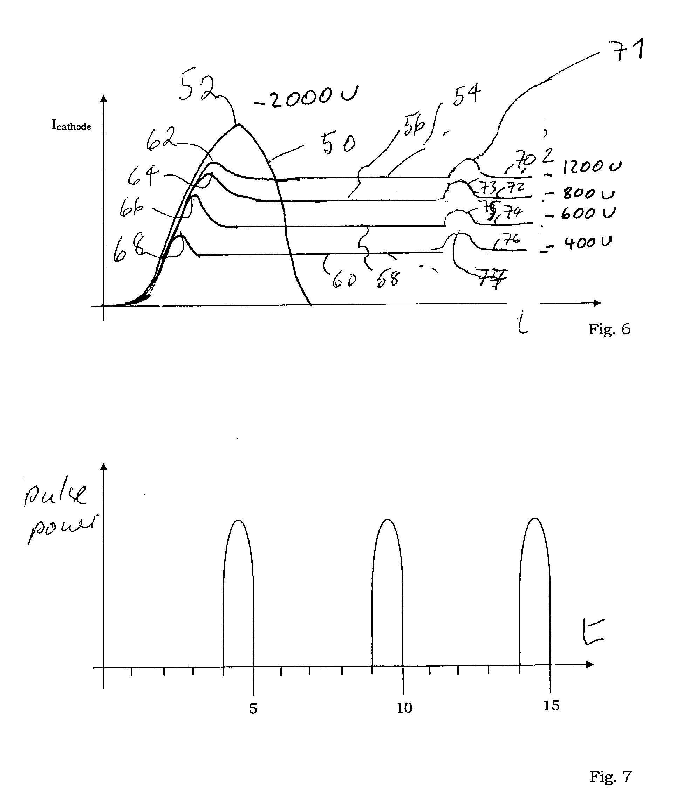

Turning now to Figs. 6 and 7 the advantage of the present invention discussed above with reference to the duty cycle and the ionization present in the chamber will now be discussed in more detail.

Fig.6 shows at 50 a curve showing the level of ionization which is achieved in arbitrary units as a function of time for a typical HIPIMS power pulse with a negative bias voltage of - 2000 V applied to the workpiece target via the bias power supply supply 46. The substrate (workpiece) bias voltage can actually be selected in the range from 0-1500V. A typical working pressure in the vacuum chamber is $1 \times 10^{-3}$ to $1 \times 10^{-2}$ mbar (although pressures outside of this range can be used if desired. Pressure can affect coating properties, but not specifically the stress. All things held constant, the stress will generally become more compressive at lower pressures and more tensile at higher pressures.

For the reactive deposition of nitride coatings the gas atmosphere is typically a mixture of argon and nitrogen. For oxide coatings it is a mixture of argon and oxygen and for carbonitride coatings it is a mixture of argon, nitrogen and a carbon forming gas such as methane or acetylene. Other inert gases can be used instead of argon, for example neon or a mixture of inert gases can be used.

It can be seen from Fig. 6 for the curve 50 that the level of ionization rises to a pronounced peak at 52 and then drops away again as the power pulse subsides. The level of ionization has a symmetrical pulse form with sharp rise and decay times. The curves 54, 56, 58 and 60 respectively represent voltages of -1200 V, -800 V, -600 V and -400 V applied to the workpieces (substrates) and have an initial rise phase culminating in respective peaks 62, 64, 66 and 68 similar to those for the HIPIMS pulse 50 but only decay to a steady level 70, 72, 74 and 76 after the pulse of power has decayed. The reason for this is that the level of ionization in the chamber is maintained at a high level by the dual magnetron cathodes 1 and 4 so that this ionization no longer has to be generated by the pulse of power applied to the further cathode or cathodes 6 and/or 7. In actual fact the graph of Fig. 6 is rather contrived. It assumes the ionization first starts with a HIPIMS type pulse whereas in practice the high level of ionization is continuously present due to the continuous operation of the dual magnetron cathodes This means that in steady state operation the application of the power pulses to the at least one further cathode 6 and/or 7 actually results in corresponding peaks on the overall level of ionization present in the vacuum chamber as shown at 71, 73, 75 and 77.

The basic advantage of the AC plasma running simultaneously with the HIPIMS plasma is that the ignition voltage for the HIPIMS discharge will be lower since free electrons are already running around the chamber. This will have no effect on the duty cycle per se. Another effect could be that the cathode impedance can be slightly lowered (more I for less V). Fig, 7 shows that the duty cycle of such power pulses can now be significantly higher than those typically used for HIPIMS. In particular Fig. 7 shows a pulse width to pulse space ratio of 1:4 indicating a duty cycle of 20%. This duty cycle can be achieved with a relatively high deposition rate which could not be used with HIPIMS alone due to thermal power limitations. The reason is simply that more of the pulse can actually be used for coating because the pulse does not first have to ionize the gas in the chamber before it becomes effective for coating.

Concerning the reactive gas, HIPIMS provides a higher plasma density and thus more reactive gas species. Ideally, as in the case of $N_2$, N+ ions can be formed. In a DC plasma, mostly N2+ ions are created. The effect is that the N2+ must first be dissociated at the growing film surface in order to be incorporated into the film. This takes additional energy, thereby reducing the adatom mobility at the growing film surface. N+ on the other hand supports high adatom mobility since it can readily react at the growing films surface.

Another point is that the overall energy and number of incident ions to the growing film surface would be higher than for DC. This can be everything from single (or multiple) charged Ar, $N_2$, N or Me.

The advantage of HIPIMS is that the Ar ion bombardment is actually reduced. It is not the most efficient or beneficial way to densify coatings and it does promote adhesion. Conversely, Ar ion bombardment tends to lead to film densification but at the cost of higher film stress and therefore poorer adhesion.

In addition to the foregoing the coatings can be deposited with a significantly higher ratio of inert gas to reactive gas. For example, with argon as the inert gas and nitrogen as the reactive gas it is possible to operate with a ratio of argon to nitrogen of 3:1 whereas in prior art systems the ratio would typically be 1:3. The reason for this is that the high level of ionization favors the formation of nitrides even with relatively lower nitrogen concentrations.

Concerning the reactive gas, HIPIMS provides a higher plasma density and thus more reactive gas species. Ideally, as in the case of $N_2$, N+ ions can be formed. In a DC plasma, mostly N2+ ions are created. The effect is that the N2+ must first be dissociated at the growing film surface in order to be incorporated into the film. This takes additional energy, thereby reducing the adatom mobility at the growing film surface. N+ on the other hand supports high adatom mobility since it can readily react at the growing films surface.

Another point is that the overall energy and number of incident ions to the growing film surface would be higher than for DC. This can be everything from single (or multiple) charged Ar, $N_2$, N or Me.

An advantage of HIPIMS is that the Ar ion bombardment is actually reduced. It is not the most efficient or beneficial way to densify coatings and it does promote adhesion. Conversely, Ar ion bombardment tends to lead to film densification but at the cost of higher films stress and therefore worse adhesion.

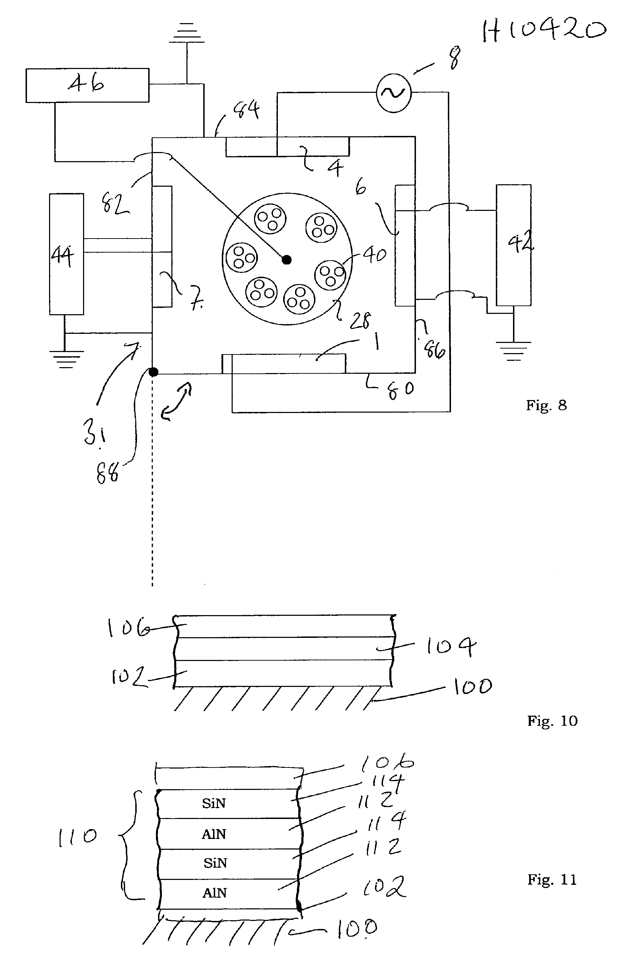

Turning now to Fig. 8 there can be seen an alternative design of vacuum chamber 31 which in this case is square in cross section rather than round and which has one openable door 80 and three fixed sides 82, 84 and 86 each carrying a respective cathode 1, 4, 6 and 7. The door 80 is pivotally mounted at 88. In principle more than one door could be provided but this is not necessary as good access can be had with just one door, More doors adds cost and complexity and makes sealing the chamber more difficult. A four sided chamber is perfectly sufficient if four cathode positions are used as in Fig. 5. The cathodes 1 and 4 again form the opposed cathodes for dual magnetron sputtering whereas the cathodes 6 and/or 7 (only one need be provided) are used for pulsed magnetron sputtering as described above. The vacuum pump system can connect to the floor or roof of the chamber and the feeds for reactive and inert gas can feed in the requisite gases or precursors through the floor and or roof of the chamber or through one of the sides or the door if this is desired and space is available for the respective connections. The gas frames and the gas feeds are not shown in Fig. 8 and many of the standard elements of a magnetron coating apparatus such as the magnetic and or electromagnetic sources for magnetron operation and dark field shields have been omitted. The person skilled in the art will be familiar with such items and there is therefore no need to show or describe them here. Although the cathodes 1 and 4 are preferably used in Figs. 5 and 8 for dual magnetron operation and the further cathodes for pulsed magnetron sputtering it will be appreciated that the basic design of the magnetron cathodes 1, 4, 6 and 7 is the same and only simple switching would be necessary to operate the cathodes 6 and 7 as the opposed cathodes for dual magnetron operation and the cathodes 1 and/or 4 for pulsed magnetron sputtering. Thus switches (not shown) can be provided to connect the dual magnetron power supply 8 to the cathodes 1 and 4 (as shown) or to connect the opposed cathodes 6 and 7 thereto. Equally switches (also not shown) can be provided to connect the pulsed power supply(ies) to the cathode(s) 1 and/or 4 instead of to the cathodes 6 and/or 7. These possibilities allow for even more flexible operation of the vacuum coating apparatus because either pair of cathodes can be provided with a material for generating a non-conductive coating with one reactive gas but a conducting coating with another reactive gas and the operation as dual magnetron cathodes or as pulsed magnetron cathodes can be selected at will in dependence on the reactive gas. Some examples for conducting/ nonconducting materials would be

AlTiN/AlTiO(N), AlCrN/AlCrO(N), TiN/TiOx.

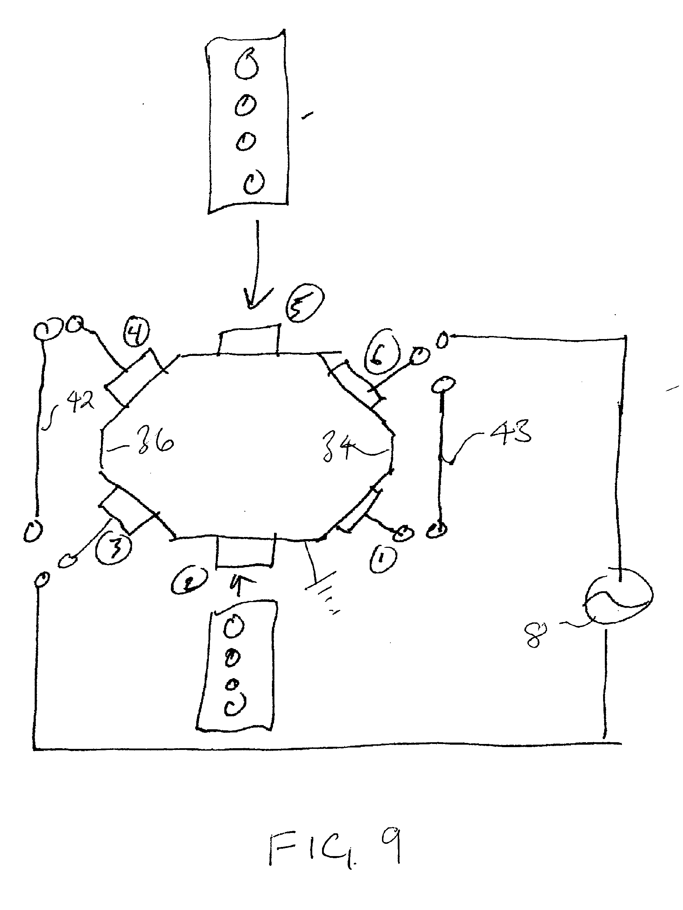

Turning now to Fig. 9 there can be seen a further vacuum coating apparatus in accordance with the present teaching. The apparatus resembles that of Fig 5. But has six cathodes arranged at six positions 1 to 6. Positions 1 and 6 are on the door34 at the right. Positions 3 and 4 are on the door 36 at the left. The positions 2 and 5 are on opposed sides of the central frame to which the doors 34, 36 are pivotally mounted. The cathodes at the positions 1 to 6 are allocated as follows:

| | |
|---|---|
| Position 1: | MPP |
| Position 2: | ARC |
| Position 3: | MPP or DMS |
| Position 4: | MPP |
| Position 5: | ARC |
| Position 6: | MPP or DMS |

In this arrangement there are only two MPP/HIPIMS supplies 42, 43. Thus only two cathodes can be run in HIPIMS mode at the same time. The ARC cathodes can be operated in DC mode or in pulse mode from Arc power supplies which are not shown. As before the AC power source 8 for the dual magnetron cathodes at the opposed positions 3 and 6 is indicated by the usual sinusoidal symbol in a circle. The further cathodes at positions 2 and 5 can, for example, be either single cathodes or at least one of them could be an array of smaller cathodes as illustrated in the rectangular boxes above and below the cathode positions 5 and 2 respectively, e.g. as described in the German utility model application 20 2010 001 497. The apparatus could be designed such that the power supply 8 adapted to supply an AC voltage to the pair of opposed cathodes 1 and 4 can be connected via switches operated in tandem to a second pair of opposed cathodes at the positions 1 and 4 or 2 and 5 within said vacuum chamber 31. Switches can also be provided to connect the power supplies 42 and 43 to the cathodes at positions 1 and 4 or 3 and 6 respectively. Suitable arc power supplies (not shown) are also provided for ARC cathodes at the positions 2 and 5.

As also brought out above magnetron sputtering cathodes for pulsed magnetron sputtering can be provided at any of said cathode positions 1 to 6 and said pulsed power supplies 42 and 44 could be connected to selected magnetron cathodes at any of said cathode positions, providing those cathodes are not operating as dual magnetron cathodes.

The apparatus of Fig. 9 is again very versatile as a large number of different coatings can be produced from the one piece of vacuum coating apparatus providing the cathodes are appropriately selected.

By way of example the following configurations are possible (among many others):

One pair of opposed cathodes can consist of one of Al, Si, AlSi, $B_4C$ or carbon, such as a vitreous carbon or graphite, for the deposition of the corresponding non conducting nitrides using a nitrogen gas atmosphere by dual magnetron sputtering. Also the pair of opposed cathodes can consist of any metal having a non-conductive oxide, such as aluminium, titanium, silicon, tantalum, zirconium, vanadium, niobium, or tungsten, or any binary alloy therefrom, optionally with an addition of any rare earth metal for the deposition of the corresponding oxides using an oxygen gas atmosphere. If two or more pairs of opposed cathodes are provided and can be operated in a dual magnetron sputtering mode then suitable choices of target (cathode) material can be made from the foregoing list for use with the corresponding reactive gas to generate a non-conductive coating without the danger of cathode poisoning.

The at least one further cathode can consist of any metals forming a conductive metal nitride or a conductive metal oxide or carbonitride. The at least one further cathode can also consist of Silicon when doped to ensure it has sufficient conductivity. The dopant can be any of the well known dopants used to give silicon p-type or n-type conductivity. Conductive nitride/oxide/carbide examples include - TiN, TiAlN, AlCrN, CrN/CrOx/TiC, TiCN, TiAlCN, AlCrCN, CrC, CrCN

When realizing the above coatings it is necessary for the vacuum chamber 31 to include a gas feed system for feeding any one of or any combination of an inert gas, for example argon or neon, a reactive gas, for example nitrogen or oxygen, and a precursor for silicon, such as $HMDSO_4$, or TMS and/or for carbon-containing gases, for example $C_2H_2$ or $CH_4$. When a silicon precursor is used, a silicon target can also be used. They are not mutually exclusive.

However, when a silicon precursor is used, then silicon does not have to be present as a target (cathode) and the at least one further cathode can be made of a different material.

The apparatus is expediently designed such that some means is provided for varying the ratio of inert gas to reactive gas. Such means could for example be an electrically or electronically controllable mixing valve (not shown) or separate controllers operating to determine the respective partial pressures of the gases in the vacuum chamber or fed into the vacuum chamber by controlling respective feed valves for the gases/precursors. The gas is especially fed in via gas frames associated with the dual magnetron cathodes as explained in connection with Figs. 1 to 4. Such means not only allow the ratio of inert gas to reactive gas or precursor to be varied they also allow optimum process control by controlling this ratio, for example as described above in conjunction with the optimum argon/nitrogen ratio.

All the magnetron cathodes are preferably UBM (Unbalanced Magnetron) cathodes and are organized in a closed field arrangement so that north and south poles alternate around the periphery of the vacuum chamber. This enables a closed magnetic field trap to be generated around the vacuum chamber thus helping to maintain a high degree of ionization in the chamber. This can be done in at least two basic ways. Before describing these ways it should first be mentioned that the magnet arrangement of a magnetron is designed to achieve a closed loop magnetic tunnel adjacent the surface of the cathode facing towards the interior of the chamber. This is achieved by a magnet arrangement at the rear surface of the cathode with a ring shaped north pole (or a plurality of adjacent north poles arranged in a closed generally rectangular or circular loop (depending on whether the cathode is of the more usual elongate rectangular or circular shape) and with a central linear south pole or an array of adjacent south poles (or with a circular south pole if a circular cathode is used). In the more usual unbalanced magnetron (UBM) the outer pole(s) are stronger than the inner pole(s). In a balanced magnetron the magnetic strengths of the inner and outer poles are comparable. Instead of having the north poles at the outside and the south poles at the center it is also possible to have the south pole(s) at the outside and the north pole(s) at the center.

In a first arrangement for achieving a closed magnetic field confinement around the vacuum chamber the magnetron cathodes are arranged with alternating magnetic polarities around the vacuum chamber such that the first has north poles at the outside, the second south poles at the outside and so on. There is usually an even number of magnetrons and these are usually realized as UBM's. In a second arrangement all magnetron cathodes have the same polarities at the outside, i.e. all with north poles at the outside or all with south poles at the outside and auxiliary south or north poles are provided between each pair of adjacent magnetron cathodes to achieve the desired alternating arrangement of north and south poles around the vacuum chamber. Further magnets can be provided at the top and bottom of the vacuum chamber, i.e. at the top and bottom of the working space to ensure the working space is entirely confined by magnetic fields. Such arrangements are known per se. The cathodes are usually realized as UBM's. That is to say auxiliary south poles are provided between the magnetron cathodes if the outer poles of the magnetrons are north poles and vice versa. Sometimes north south and north auxiliary poles are provided between adjacent magnetrons if these have external south poles and vice versa. Such an arrangement can be helpful if there is a wide spacing between adjacent magnetrons.

Some examples will now be given of different coatings which can be realized using the above described apparatus.

Examples 1 to 4

First of all, as illustrated in Fig. 10 a three layer coating can be provided on a typical substrate 100 which can, for example, consist of any one of a cermet, a carbide, such as tungsten or boron carbide, a carbonitride or another hard material such as a steel, especially HSS or tool steel. The substrate 100 is preferably first cleaned and etched which can for example be done by conventional argon ion etching using one of the at least one further cathodes at a high substrate bias voltage, or by using the HIPIMS method described in European patent 1260603, or by the alternative method described in The German utility model application 20 2010 001497.

Thereafter a bond layer or transition layer 102 is deposited on the substrate 100. This bond layer 102 could for example be a Ti layer (Example 1), a Cr layer (Example 2) or a TiN or CrN layer (Examples 3 and 4). Such layers can be deposited in the following ways:

Ti from a Ti cathode operated as a pulsed magnetron cathode (or as a DC magnetron cathode if a suitable power supply is provided),

Cr from a Cr cathode operated as a pulsed magnetron cathode (or as a DC magnetron cathode if a suitable power supply is provided),

TiN or CrN by reactive sputtering of Ti or Cr as above but in an atmosphere comprising an inert gas such as argon and nitrogen,

On top of the bond layer 102 there is then deposited a nanocomposite layer 104 comprising AlSiN.The AlSiN must be made with AlSi targets on dual magnetron setup or with Al and Si targets on two pairs of dual magnetron cathodes. Doped Si targets are conductive, but SiN is insulating. For the deposition of this layer the aluminum can be deposited from the dual magnetron cathodes 1 and 4 in Fig. 5 which consist of aluminum in a reactive atmosphere of nitrogen in an argon nitrogen mixture.

The SiN is deposited using Si at at least one of the further cathodes simultaneously with the aluminium from the dual magnetron cathodes and in the same reactive atmosphere. The silicon is doped to render it conductive. The substrate (workpiece) bias, the pulsed power supply to the at least one further cathode (6 and/or 7 in the Fig. 5 embodiment), the power supply to the dual magnetron cathodes and the working pressure in the vacuum chamber as well as the ratio of argon to nitrogen are selected in accordance with the considerations given above to achieve the desired uniform nanocomposite coating 104 with the appropriate optimum hardness as determined by the composition of the layer (6 to 9% Si in Al with approximately the desired stoichiometric amount of nitrogen) and residual stress value as determined by the pulsed cathode power supply delivered to the at least one further cathode 6 and/or 7 and by the working pressure in the vacuum chamber. The nanocomposite coating would typically have a thickness of 0.1-10um. "

After deposition of the layer 104 a further layer or cover layer 106 of $Al_2O_3$ is deposited on it. This is done by using the dual magnetron cathodes 1nd 4 of aluminum but with a reactive atmosphere of oxygen rather than nitrogen, again in a mixture with an inert gas such as argon. To change from nitrogen to oxygen it is simply necessary to interrupt the coating process for a short time while oxygen is used to flush the nitrogen from the vacuum chamber Actually this is not essential since continuous coating of aluminum during the change of the reactive gas would simply lead to a graded transition from Al N to $Al_2O_3$. The $Al_2O_3$ layer is typically about 0.1-10um thick.

Examples 5 to 12.

These are basically the same as Examples 1 to 4 but in examples 5 to 8 the bond layer is omitted (since it is not essential on certain substrates). For example, asuch as AlCrN/AlN, CrSiN/AlN. For example a bond layer would not be needed for WC substrates and some types of steels (tool and die steels).
In examples 9 to 12 the $Al_2O_3$ layer 196 is omitted,

Examples 13 to 16

In these examples illustrated in Fig, 11 a bond layer 102 is again provided on the substrate 100 and indeed its composition and the method of deposition is the same as quoted above for examples 1 to 4. Thereafter a multilayer coating 110 consisting of alternating thin layers 112 of AlN and 114 of SiN are provided by simultaneous operation of the cathodes 1 and 4 and 6 and 7 in the same manner as described above in connection with Examples 1 to 4. The only difference is that the speed of rotation of the workpieces about the central axis of the vacuum chamber on the table 28 (one fold rotation) - optionally with simultaneous rotation of the workpieces about the vertical axis of the individual table 40 (two fold rotation) and optionally with rotation of the workpieces on radial arms of supports carried by the tables 40 about their own axes (three fold rotation) - is selected such that the multilayer system arises due to the rotation of workpieces on the table 28 in front of the respective cathodes. The speed of rotation defines the dwell time in the coating fluxes from the respective cathodes and this determines the layer thickness. The total number of multilayers is defined by appropriately selecting the total coating time in conjunction with the speed of rotation. When depositing multilayers there is a gradual change in composition between the individual layers but this is not disadvantageous and indeed can be beneficial.
In further examples the multilayer system can be provided with a layer 106 of $Al_2O_3$ as described above with reference to examples 1 to 4 and the bond layer system can also be omitted. In further Examples the layer systems in the following table could readily be used, T1, T2 etx. represent the respective targets (cathodes):....

| Coating | T1 | T2 | T3 | T4 | T5 | T6 |
|---|---|---|---|---|---|---|
| TiN/TiAlN/TiSiN | Ti | Al | Si | Ti | Al | Si |
| TiAlN/SiC/CN | TiAl | Si | C | TiAl | Si | C |
| CrN/AlCrN/AlCrSiN | Cr | Al | Si | Cr | Al | Si |
| TiAlN/TiSiN/Al2O3 | Ti | Al | Si | Ti | Al | Si |

The nitride N and oxide O components are supplied by the use of reactive gases nitrogen and oxygen in the coating apparatus, i.e. in the vacuum chamber.
Thus the present invention contemplates a substrate selected from the group comprising cermets, metal carbides, hard metals, steels, and a coating thereon consisting of a composite of any one of TiN, TiAlN, AlTiN, AlCrN, and intermixed SiN, optionally with the additions of any rare earth material and optionally having a surface layer, or interspersed layers, or a mixed layer of $Al_2O_3$, AlCrO, AlSiO
Other examples are:

AlTiN+AlTiN/AlTiSiN+AlTiSiN+Al2O3 and

AlCrN+AlCrSiN+AlCrO+AlCrON

List of Reference Numerals

1       Cathode

| | |
|---|---|
| 2 | Cathode |
| 3 | Cathode |
| 4 | Cathode |
| 5 | Cathode |
| 6 | Cathode |
| 7 | Cathode |
| 8 | Dual magnetron power supply |
| 9 | Gas frame |
| 10 | Gas frame |
| 12 | $O_2$ inlet valve |
| 14 | $O_2$ inlet valve |
| 16 | Vacuum pump |
| 18 | Feedback regulator |
| 20 | Feedback regulator |
| 22 | Argon inlet location |
| 28 | Rotary table |
| 30 | Regulator |
| 31 | Vacuum chamber |
| 32 | Regulator |
| 33 | Central portion vacuum chamber |
| 34 | Hinged door of vacuum chamber |
| 36 | Hinged door of vacuum chamber |
| 38 | Direction of rotary |
| 40 | Smaller rotary table |
| 42 | Pulsed magnetron sputtering power supply |
| 44 | Pulsed magnetron sputtering power supply |
| 46 | Pulsed bias mode power supply for substrate (workpiece bias |
| 50 | curve |
| 52 | peak |
| 54 | curve |
| 56 | curve |
| 58 | curve |
| 60 | curve |
| 62 | peak |
| 64 | peak |
| 66 | peak |
| 68 | peak |
| 70 | steady level |
| 71 | corresponding peak |
| 72 | steady level |
| 73 | corresponding peak |
| 74 | steady level |
| 75 | corresponding peak |
| 76 | steady level |
| 77 | corresponding peak |
| 80 | openable door |
| 82 | fixed sides |
| 84 | fixed sides |
| 86 | fixed sides |
| 88 | pivot |
| 100 | substrate |
| 102 | bond layer |
| 104 | nanocomposite layer |
| 106 | cover layer |
| 110 | multi-layer |
| 112 | thin layer of AlN |
| 114 | thin layer of SiN |

**Claims**

1.  Vacuum coating apparatus comprising a vacuum chamber, at least one pair of opposing cathodes (1, 4), a power supply (8) adapted to supply an AC voltage to said opposing cathodes (1, 4) to operate them in a dual magnetron sputtering mode, wherein at least one further cathode (6 and/or 7) for PVD coating is provided in said vacuum chamber, **characterized in that** the at least one further cathode (6 and/or 7) is a magnetron cathode or arc cathode and a further power supply (42 and/or 44) in the form of a pulsed power supply or a DC power supply is provided which is connectable to the magnetron cathode or arc cathode.

2.  Apparatus in accordance with claim 1, wherein the further power supply (42 and/or 42) is one of a HIPIMS power supply, a modulated pulse power supply and a pulsed power supply with a maximum duty cycle in the range from 1 to 35 %, preferably 3 to 33 %, and especially from 10 to 30 %

3.  Apparatus in accordance with claim 1 or claim 2, wherein the pulsed power supply (42 and/or 44) has a pulse repetition frequency preferably from 1 to 2 kHz, if required from 1 to 400 Hz, and optionally from 10 to 200 Hz.

4.  Apparatus in accordance with any one of the preceding claims,
    wherein said apparatus is adapted for simultaneous operation of said pair of opposing cathodes (1 and 4) and said at least one further cathode (6 and/or 7).

5.  Apparatus in accordance with any one of the preceding claims, wherein the vacuum chamber has either four or six cathode positions, there being two opposed cathode positions for the said pair of opposed cathodes and at least first and second further cathode positions for further cathodes, said further cathodes being either single cathodes or arrays of further cathodes.

6.  Apparatus in accordance with claim 5, wherein the power supply (8) adapted to supply an AC voltage to said pair of opposed cathodes (1 and 4) is connectable to any pair of opposed cathodes (6 and 7 and/or 2 and 3) within said vacuum chamber.

7.  Apparatus in accordance with claim 6, wherein first and second pairs of opposed cathodes ((1 and 4) and (6 and 7)) are provided at first and second and third and fourth cathode positions within said vacuum chamber and a power supply (8) adapted to supply an AC voltage to a pair of opposed cathodes is connectable to each of said pair of opposed cathodes ((1 and 4) and (6 and 7)).

8.  Apparatus in accordance with any one of the preceding claims, wherein magnetron sputtering cathodes are provided at any of said cathode positions and said pulsed power supply (42 and/or 44) can be connected to selected magnetron cathodes at any of said cathode positions.

9.  Apparatus in accordance with any one of the preceding claims, wherein said pair of opposed cathodes consists of one of Al, Si, AlSi, $B_4C$ or carbon, such as a vitreous carbon or graphite, for the deposition of the corresponding nitrides using a nitrogen gas atmosphere or consists of any metal having a non-conductive oxide, such as aluminium, titanium, silicon, tantalum, zirconium, vanadium, niobium, or tungsten, or any binary alloy therefrom, optionally with an addition of any rare earth metal for the deposition of the corresponding oxides using an oxygen gas atmosphere.

10. Apparatus in accordance with claim 9, wherein at least one further cathode consists of metals forming a metal nitride with the exception of aluminium nitride or of silicon doped to render it conductive

11. Apparatus in accordance with any one of the preceding claims and including a gas feed system for feeding any one of or any combination of an inert gas, for example argon or neon, a reactive gas, for example nitrogen or oxygen, and a precursor for silicon, such as $HMDSO_4$, or TMS, optionally in combination with an Si target, and/or carbon-containing gases, for example $C_2H_2$ or $CH_4$.

12. Apparatus in accordance with claim 11, **characterized in that** a control means is provided for varying the ratio of inert gas to reactive gas.

13. Apparatus in accordance with any one of the preceding claims, wherein all magnetron cathodes are UBM (Unbalanced Magnetron) cathodes and are organized in a closed field arrangement so that north and south poles alternate around the periphery of the vacuum chamber.

**14.** A method of manufacturing a coating on a substrate in a vacuum chamber having at least one pair of opposed cathodes (1 and 4) and an AC power supply (8) connectable to operate said cathodes (1 and 4) in a dual magnetron sputtering mode and at least one further cathode (6 and/or 7), an associated power supply, **characterized in that** the at least one further cathode (6 and/or 7) and the pair of opposing cathodes (1 and 4) are operated simultaneously whereby a an ionized plasma is established in the vacuum chamber between said opposed cathodes (1 and 4) and favors the operation of the at least one further cathode (6 and/or 7) due to the presence of the ionized plasma.

## Fig.1

EP 2 565 291 A1

Fig. 2C

CATHODE
4

0

V₄

Fig. 2B

CATHODE
1

0

V₁

Fig. 2A

AC
SOURCE
8

V

Fig.3

Fig. 4

Fig. 5

Fig. 6

Fig. 7

H10420

Fig. 8

Fig. 10

Fig. 11

FIG. 9

Europäisches
Patentamt

European
Patent Office

Office européen
des brevets

# EUROPEAN SEARCH REPORT

**Application Number**

EP 11 00 7077

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2009/052874 A1 (HAUZER TECHNO COATING BV [NL]; TIETEMA ROEL [NL]; PAPA FRANK [NL]; SES) 30 April 2009 (2009-04-30) * pages 11,18; figures 1,3,6,10 * ----- | 1-14 | INV. C23C14/06 C23C14/08 C23C14/14 C23C14/35 H01J37/34 |
| X | KAMATH G ET AL: "Properties of TiAlCN/VCN Nanoscale Multilayer Coatings Deposited by Mixed High-Power Impulse Magnetron Sputtering (HiPIMS) and Unbalanced Magnetron Sputtering Processes - Impact of HiPIMS During Coating", IEEE TRANSACTIONS ON PLASMA SCIENCE, vol. 38, no. 11, 23 July 2010 (2010-07-23) , pages 3062-3070, XP011314237, IEEE SERVICE CENTER, PISCATAWAY, NJ [US] ISSN: 0093-3813, DOI: 10.1109/TPS.2010.2052473 * the whole document * ----- | 1-14 | |

TECHNICAL FIELDS
SEARCHED (IPC)

C23C
H01J

The present search report has been drawn up for all claims

| Place of search | Date of completion of the search | Examiner |
|---|---|---|
| Munich | 29 November 2011 | Hoyer, Wolfgang |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 11 00 7077

This annex lists the patent family members relating to the patent documents cited in the above-mentioned European search report.
The members are as contained in the European Patent Office EDP file on
The European Patent Office is in no way liable for these particulars which are merely given for the purpose of information.

29-11-2011

| Patent document cited in search report | Publication date | Patent family member(s) | Publication date |
|---|---|---|---|
| WO 2009052874 A1 | 30-04-2009 | NONE | |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 07819370 A
- WO 2008049634 A
- DE 22301009497
- DE 202010001497
- EP 1260603 A

**Non-patent literature cited in the description**

- **STAN VEPREK ; PAVLA KARVANKOVA ; MARITZA G.J VEPREK-HEIJMAN.** Possible role of oxygen impurities in degradation of nc- TiN/Si3N4 nanocomposites. *J. Vac. Sci. Tech.,* 23 November 2005, vol. B23 (6), L17-L21
- **SHIQIANG HAO ; BERNHARD DELLEY ; STAN VEPREK ; CATHERINE STAMPFL.** Superhard Nitride-Based Nanocomposites, Role of Interfaces and Effect of Impurities. *Physical Review Letters PRL,* 2006, vol. 97, 086102-1086102-4
- Different approaches to superhard coatings and nanocomposites. **STAN VEPREK ; MARITZA G.J VEPREK-HEIJMAN ; PAVLA KARVANKOVA ; JAN PROCHAZKA.** Thin Solid Films. Elsevier, 2005, vol. 476, 1-29